# EUROPÄISCHE PATENTSCHRIFT

(11) **EP 2 912 687 B1**
(45) Veröffentlichungstag und Bekanntmachung des Hinweises auf die Patenterteilung: **12.08.2020**
(21) Anmeldenummer: 13795184.4
(22) Anmeldetag: 25.10.2013
(51) Int. Cl.: H01L 23/00, H01L 27/02

(54) **INDIVIDUALISIERTE SPANNUNGSVERSORGUNG VON BAUELEMENTEN INTEGRIERTER SCHALTUNGEN ALS SCHUTZMASSNAHME GEGEN SEITENKANALANGRIFFE**
INDIVIDUALISED VOLTAGE SUPPLY OF INTEGRATED CIRCUITS COMPONENTS AS PROTECTIVE MEANS AGAINST SIDE CHANNEL ATTACKS
ALIMENTATION EN TENSION INDIVIDUALISÉE DE COMPOSANTS DE CIRCUITS INTÉGRÉS EN TANT QUE MESURE DE PROTECTION CONTRE LES ATTAQUES PAR CANAUX AUXILIAIRES

(30) Priorität: 26.10.2012 DE 102012219661
(43) Veröffentlichungstag der Anmeldung: 02.09.2015
(73) Patentinhaber: IHP GmbH-Innovations for High Performance Microelectronics / Leibniz-Institut für innovative Mikroelektronik, 15236 Frankfurt / Oder (DE)
(72) Erfinder: DYKA, Zoya, 15230 Frankfurt (Oder) (DE); LANGENDÖRFER, Peter, 15234 Frankfurt (Oder) (DE)
(74) Vertreter: Eisenführ Speiser
(86) Internationale Anmeldenummer: PCT/EP2013/072447
(87) Internationale Veröffentlichungsnummer: WO 2014/064275

(56) Entgegenhaltungen:
- WO-A2-2009/031057
- US-A1- 2011 049 684

## Beschreibung

Die Erfindung betrifft eine Halbleitervorrichtung, insbesondere eine integrierte Schaltung mit Schutz gegen Seitenkanalangriffe, insbesondere Imaging- und Probing-basierte Angriffe, EMA und Reverse Engineering.

Integrierte Schaltungen können sicherheitsrelevante oder geheimhaltungsbedürftige Informationen beinhalten oder verarbeiten. Daher werden Daten, die solche Informationen tragen, verschlüsselt. Eine integrierte Schaltung (IC, engl. integrated circuit), die verschlüsselte Daten verarbeitet oder speichert, oder die unverschlüsselte Daten verschlüsselt, wird im Rahmen der vorliegenden Anmeldung als kryptographische Schaltung, oder gleichbedeutend kryptographische Halbleitervorrichtung bezeichnet.

Angriffe gegen kryptographische Schaltungen zielen auf Informationen, die eine Entschlüsselung der von der Schaltung verarbeiteten oder gespeicherten Daten ermöglichen. Um an diese Informationen zu gelangen, werden sowohl Analysen der messbaren analogen Parameter einer Schaltung (Ausführungszeit der Operationen, Energieverbrauch) oder der physikalischen Parameter ihrer Umgebung (Schall, elektromagnetische Strahlung) als auch Analysen der inneren Struktur der Schaltung eingesetzt.

Die Analyse der analogen Parameter der Schaltung oder der physikalischen Parameter ihrer Umgebung kann häufig über nichtinvasive Methoden erfolgen. Bereits die Kenntnis der analogen Schaltungsparameter sowie der Änderungen der physikalischen Parameter der Umgebung einer aktiven Schaltung lassen Rückschlüsse auf in einer Schaltung verwendete Schlüssel zu SEMA (engl. simple electromagnetic analysis), DEMA (engl. differential electromagnetic analysis) und CEMA (engl. correlation electromagnetic analysis) sind verschiedene bekannte Arten einer elektromagnetischen Analyse EMA (electromagnetic analysis). Sie gehören zur Klasse relativ billiger nicht-invasiver Angriffe und basieren auf der Analyse der elektro-magnetischen Strahlung in der näheren Umgebung einer kryptographischen Schaltung, die in einer Halbleitervorrichtung enthalten ist.

Als Gegenmaßnahmen gegen EMA sind Abschirmungen des Bauelementes, Änderungen des Signal-Rausch-Verhältnisses und die Einführung von Maskierungen bekannt. Eine elementare Abschirmung integrierter Schaltungen in Form eines Faraday-Käfigs zum elektrostatischen Schutz des Bauelementes und als Schutzmaßnahme gegen die Ausbreitung elektromagnetischer Strahlung, die eine arbeitende Schaltung verursacht, ist beispielsweise aus US 8,049,119 B2 ist bekannt. Die Anwendung eines Chip-Gehäuses als Träger eines Teils einer internen Erdungsschicht für die Abschirmung einer integrierten Schaltung wird in US 6,865,804 B2 beschrieben. US 6,243,265 B1 zeigt eine Verbindung eines Kühlkörpers eines ICs mit dem 0V-Potential und die Nutzung dieser Anordnung zur Abschirmung des ICs. Solche Abschirmungs-Maßnahmen können gegen nicht-invasive EMA schützen. Das Entfernen dieser Schutz-Schichten, das für eine erfolgreiche EMA dann zusätzlich notwendig ist, ist in diesen bekannten Ausführungen jedoch mit relativ wenig Aufwand möglich.

Um Kenntnisse über die innere Struktur einer kryptographischen Schaltung zu erlangen, werden invasive und semi-invasive Angriffe durchgeführt, mit denen ein optischer Zugang zur inneren Struktur der Schaltung hergestellt werden soll. Die Schaltung muss bei einem solchen invasiven oder semi-invasiven Angriff entpackt werden, wobei ihre innere Struktur funktionsfähig bleiben muss, um z. B. kryptographische Operationen weiterhin ausführen zu können. Falls die Struktur zerstört wird, muss diese wiederhergestellt werden, um die Operationen beobachten zu können. Unter einem Probing-.basierten Angriff versteht man eine lokale messtechnische Erfassung der Werte von Speicher- oder Schaltungselementen während der Ausführung beispielsweise eines kryptographischen Algorithmus durch die kryptographische Schaltung.

Als Maßnahme gegen semiinvasive und invasive Angriffen ist vor allem der Einsatz aktiver Sensorik bekannt, um mechanische Angriffe zu detektieren und in Reaktion darauf Strukturinformationen des angegriffenen Halbleiterbauelements unbrauchbar zu machen. US 2010/0078636 A1 beschreibt zum Beispiel die Einbringung von lichtemittierenden und lichtsensitiven Bauteilen sowie einer reflektierenden Rückwand, so dass bei einer Beschädigung der Rückwand das von den lichtsensitiven Bauteilen empfangene Signal gestört wird. US 7,989,918 B2 zeigt die Verwendung eines Kondensators, dessen Kapazität sich ändert, wenn eine Chipdicke verringert wird, sowie eines Ringoszillatorschaltkreises, der diese Kapazitätsänderung detektiert. In US 8,143,705 B2 wird eine elektrisch leitfähige Schutzschicht verwendet, deren Widerstand gemessen wird, wobei im Falle einer Beschädigung der Schutzschicht deren Widerstandsänderung zur Generierung eines vom Referenzcode abweichenden Codes führt.

US 2011/049684 A1 beschreibt einen IC, der eine Bauelementenschicht mit einer Anzahl von Halbleiterbauelementen und einen Leitbahnstapel umfasst. Der Leitbahnstapel beinhaltet eine Anzahl von Leitbahnen, die die Halbleiterbauelemente miteinander verbinden und in einem dielektrischen Material eingebettet sind. Weiterhin sind in dem dielektrischen Material des Leitbahnstapels eine Anzahl von festen Nanopartikeln eingebettet. Die Nanopartikel weisen einen Härtegrad auf, der größer als der des dielektrischen Materials und der Leitbahnen ist.

WO 2009/031057 A2 offenbart einen Chip für Sicherheitsanwendungen. Der Chip umfasst ein Substrat und einen auf dem Substrat aufgebrachten IC. Der IC umfasst Schaltkreisbauelemente, Schaltkreisleiterebenen, die die Schaltkreisbauelemente miteinander verbinden, und Zwischenebenenkontakte, die die Schaltkreisleiterebenen miteinander verbinden. Weiterhin umfasst der Chip eine Abschirmung, die den IC zumindest teilweise abschirmt, und mindestens einen Lichtschacht in der Abschirmung und im IC. Der mindestens eine Lichtschacht hat eine geschlossene Form, die durch Teile der Schaltkreisleiterebenen und der Zwischenebenenkontakte hergestellt wird. Jeder Lichtschacht formt einen Pfad, um Licht in das Substrat zu leiten und um zu verhindern, dass Licht den IC erreicht.

Erfindungsgemäß wird eine Halbleitervorrichtung vorgeschlagen, mit
- einem Substrat,
- einer Bauelementschicht auf dem Substrat, welche eine Vielzahl von elektronischen Schaltungskomponenten in Form von monolithisch integrierten EinzelBauelementen oder Logikgattern beinhaltet,
- einem Leitbahnstapel auf einer vom Substrat abgewandten Seite der Bauelementschicht,
- einer ersten monolithisch integrierten Potentialzuführung die mit einem elektrischen Referenz-Potential verbunden oder verbindbar ist, und
- einer zweiten monolithisch integrierten Potentialzuführung, die mit einem elektrischen Versorgungspotential verbunden oder verbindbar ist, wobei in der letztgenannten Alternative die erste und die zweite Potentialzuführung jeweils mindestens eine metallisch leitfähige Schicht aufweisen,
- die metallisch leitfähige Schicht der ersten und der zweiten Potentialführung durch mindestens eine dielektrische Schicht von einander getrennt sind, und wobei
die metallisch leitfähige Schicht der ersten und/oder der zweiten Potentialzuführung mit allen Schaltungskomponenten jeweils einzeln über jeweils individuelle Leitbahnstrukturen direkt verbunden sind.

Die vorliegende Erfindung stellt eine Halbleitervorrichtung bereit, die sowohl gegen nicht-invasive (EMA, PA) als auch gegen invasive oder semi-invasive Angriffe geschützt ist. Bekannte Schutzmaßnahmen wirken dagegen oft nur gegen einzelne Angriffe, also entweder bei EMA oder gegen Struktur-Analyse oder gegen optische Angriffe. Die Entwicklung eines Schutzmechanismus, der gegen mehrere Angriffsarten gleichzeitig wirksam ist, ist daher besonders vorteilhaft und erleichtert die Realisierung sicherer Hardware-Implementierungen von kryptographischen Algorithmen.

Die Erfindung beruht auf der Erkenntnis, dass bei der Durchführung von invasiven und semi-invasiven Angriffe eine Halbleitervorrichtung auch nach dem Entpacken in einem funktionsfähigen Zustand bleiben müsste, damit der Angreifer die Funktionalität der Schaltung (oder eines Teils der Schaltung) verstehen oder beeinflussen kann und Schlüssel extrahieren kann. Dazu müssten unter anderem alle Gatter nach dem Entpacken mit der Betriebsspannung (Versorgungspotential V_{dd} und Referenzpotential GND) versorgt sein.. Die Gatter werden im Stand der Technik typischerweise an eine gemeinsame GND-Leitbahn und eine gemeinsame Vdd-Leitbahn angeschlossen. Diese beiden Leitbahnen werden in einer gemeinsamen Metallschicht abwechselnd angeordnet, um Gatter, Transistoren oder Standardzellen möglichst leicht anschließen zu können. Im Stand der Technik geschieht dies in der Regel in der ersten Metallschicht des Leitbahnstapels (M₁), die direkt über der Bauelementschicht angeordnet ist.

Die mindestens eine metallisch leitfähige Schicht in der erfindungsgemäßen Halbleitervorrichtung wirkt nicht nur als eine Abschirmung der elektromagnetischen Strahlung -also gegen einen EMA-Angriff-, sondern ist darüber hinaus ein Sichtschutz für die tieferliegenden Schichten. So können semi-invasive Angriffe wie Imaging und Fehlerinjektion mittels optischer, UV-, und Laser-Strahlung behindert werden. Die metallisch leitfähige Schicht müsste bei einem Angriff daher entfernt oder zumindest beschädigt werden, um den Angriff durchführen zu können. Da diese metallisch leitfähige Schicht in ihrer Funktion als Potentialzuführung aber die Versorgung der Einzelbauelemente oder Logikgatter mit dem Versorgungspotential der Betriebsspannung oder dem Referenzpotential bereitstellt, ist die Halbleitervorrichtung nach Entfernung dieser metallisch leitfähigen Schicht nicht mehr funktionsfähig. Die Versorgung mit der Betriebsspannung müsste dann erst wieder an alle zuvor mit der metallisch leitenden Schicht einzeln verbundenen Schaltungskomponenten wiederum einzeln angeschlossen werden. Die Wiederherstellung dieser Kontaktierungen ist jedoch zeit- und geldaufwendig, da die Anzahl der Logikgatter z. B. bei kryptographischen Algorithmen typischerweise mehrere Tausend beträgt. Die Versorgung könnte zwar beispielsweise mit Hilfe einer FIB (Focused Ion Beam) Anlage wiederhergestellt werden. Dabei müssen aber geeignete Kontaktierungen für alle zuvor angeschlossenen Schaltungskomponenten einzeln implantiert werden. Der Aufwand allein für das Implantieren einer Fläche (also ohne Berücksichtigung der Vorbereitungszeit) von nur 10 µm x 1µm beträgt schon ca. 30 Minuten, ist also sehr hoch und macht einen solchen Angriff somit unattraktiv.

Nachfolgend werden Ausführungsbeispiele der erfindungsgemäßen Schichtstruktur beschrieben. Die zusätzlichen Merkmale der Ausführungsbeispiele können miteinander kombiniert werden, um weitere Ausführungsbeispiele zu bilden, es sei denn, sie sind ausdrücklich als Alternativen zueinander beschrieben.

Die mindestens eine metallisch leitfähige Schicht der erfindungsgemäßen Halbleitervorrichtung ist bevorzugt in einer Ebene angeordnet, die von der Bauelementschicht weiter entfernt angeordnet ist als die erste Metallschicht des Leitbahnstapels.

Anstelle der Ausbildung nur der ersten Potentialzuführung (GND) oder nur der zweiten Potentialzuführung (V_{dd}) als mindestens eine metallisch leitfähige Schicht können auch beide Potentialzuführungen zugleich, also die erste und die zweite Potentialzuführung in Form der jeweils einen oder mehreren metallisch leitfähigen Schichten ausgeführt sein. Ist dies der Fall, verstärkt sich der Schutzeffekt, da nun beide Potentialzuführungen entfernt werden müssten, um optischen Zugang zur Bauelementschicht zu erhalten und die Abschirmwirkung aufzuheben. Damit wächst der Aufwand für die Wiederherstellung der Kontaktierung, und es ist gegebenenfalls Zusatzwissen notwendig, um die Kontaktierung korrekt vornehmen zu können. Hinzu kommt bei dieser Ausführungsform, dass für beide Potentiale, also Versorgungs- und Referenzpotential, vor dem Angriff jeweils mindestens eine metallisch leitfähige Schicht in je einer Ebene vorgesehen ist. Nach dem Entfernen dieser Schichten bei einem Angriff müssten die entsprechenden Verdrahtungen zu beiden Potentialen aber in nur einer Ebene realisiert werden. Auch dies erhöht den Aufwand zur Rekonstruktion signifikant.

In dieser Ausführungsform ist mindestens eine der beiden Potentialzuführungen, das heißt metallisch leitfähigen Schichten nicht in der untersten Metallisierungsebene (M1) realisiert. Vorzugsweise sind beide metallisch leitfähige Schichten beider Potentialzuführungen nicht in der untersten Metallisierungsebene M1 realisiert, sondern in höheren Metallisierungsebenen, wie weiter unten anhand von weiteren Ausführungsbeispielen mit verschiedenen Varianten erläutert wird.

In einer alternativen Ausbildung der Halbleitervorrichtung sind die metallisch leitfähige Schicht der ersten und der zweiten Potentialzuführung lateral benachbart in einer gemeinsamen, parallel zu einer Hauptoberfläche des Substrats liegenden Ebene angeordnet und von einander elektrisch isoliert. Beispielsweise könnte eine (in Bezug auf die lateralen Ausmaße der Halbleitervorrichtung) linke Hälfte der betreffenden Ebene als metallisch leitfähige Schicht einer GND-Potentialzuführung und eine rechte Hälfte als Vdd-Potentialzuführung dienen. Zwischen den beiden Hälften ist eine elektrische Isolierung vorgesehen. Auf diese Weise kann zum weiter verbesserten Schutz der Halbleitervorrichtung der notwendige intellektuelle Aufwand beim Wiederherstellen der Kontakte im Falle eines Angriffs noch erhöht werden.

Im Folgenden werden Varianten beschrieben, die verschiedene Möglichkeiten der Ausbildung der metallisch leitfähigen Schicht betreffen, welche die Potentialzuführung bildet. Die mindestens eine metallisch leitfähige Schicht des ersten Kontaktes oder des zweiten Kontaktes bildet in einer Ausführungsform vorteilhaft eine Fläche, die entweder vollständig ohne Öffnungen ist oder abgesehen von mindestens einer Via-Durchführung oder von geringfügigen Öffnungen zur Vermeidung mechanischer Spannungen ohne Öffnungen ist und deren senkrechte Projektion auf die Bauelementschicht diese im wesentlichen oder vollständig überdeckt. Auch eine in einer Fläche in einer Ebene liegende geschlossene Ebene ist vorteilhaft, insbesondere, wenn sie in der obersten Metallisierungsebene des Leitbahnstapels angeordnet ist. Sie muss jedoch nicht als geschlossene Fläche ausgebildet sein. In einer Variante enthält die metallisch leitfähige Schicht Öffnungen, die beispielsweise zur Durchleitung von Verbindungselementen (Vias) genutzt werden können, oder auch nur mit einem dielektrischen Material verfüllt sind. Alternativ kann die metallisch leitfähige Schicht als ein zusammenhängendes, in einer einzigen Schichtebene liegendes Netz metallischer Leitbahnen oder als ein zusammenhängendes, in einer einzigen Schichtebene liegendes Gitter aus metallisch leitfähigen Leitbahnen ausgebildet sein. Ein Gitter unterscheidet sich in diesem Zusammenhang durch seine durchgehend regelmäßigen, rechtwinkligen Strukturen von einem Netz, das auch unregelmäßige und nicht rechtwinklige Strukturen beinhalten kann. All diesen alternativen Ausführungsformen der metallisch leitfähigen Schicht ist gemeinsam, dass sie die elektromagnetische Strahlung, die von einer arbeitenden Schaltung ausgeht, abschirmen und zugleich einen Sichtschutz zur inneren Struktur der Schaltung bieten.

Vorteilhaft ist es, wenn mindestens einer der Kontakte Durchführungen mit senkrecht zur Schicht verlaufenden VIAs (Vertical Interconnect Access) aufweist, über die beispielsweise weitere metallische Ebenen des Leitbahnstapels oder der andere Kontakt mit den Schaltungskomponenten verbunden sind. Diese Durchführungen bilden vorteilhafter weise Öffnungen, welche an ihrem Rand zur metallisch leitfähigen Schicht hin eine elektrische Isolation aufweisen.

Bei der oben bereits erwähnten Ausbildung der Halbleitervorrichtung, bei der die metallisch leitfähige Schicht der ersten und der zweiten Potentialzuführung lateral benachbart in einer gemeinsamen, parallel zu einer Hauptoberfläche des Substrats liegenden Ebene angeordnet und von einander elektrisch isoliert sind, ist bevorzugt eine senkrechte Projektion dieser metallisch leitfähigen Schichten der ersten und der zweiten Potentialzuführung auf die Bauelementschicht die Bauelementschicht im wesentlichen oder vollständig überdeckt. Dies gilt selbstverständlich abgesehen von einem notwendigen lateralen Abstand, der für die elektrische Isolierung der beiden metallisch leitfähigen Schichten der ersten und der zweiten Potentialzuführung voneinander innerhalb der gemeinsamen Ebene erforderlich ist. Dieser Abstand ist typischerweise mit einem Dielektrikum verfüllt. In Varianten dieser Ausführungsform werden komplexere flächenmäßige Partitionierungen der betreffenden Ebene durch die metallisch leitfähigen Schichten der beiden Potentialzuführungen verwendet als Hälften, nämlich beispielsweise Drittel, Viertel, Schachbrettmuster oder ähnliches. Die Teilflächen dieser Partitionierungen sind von einander elektrisch isoliert, soweit sie unterschiedlichen Potentialen zugeordnet sind. Die elektrische Verbindung der jeweiligen Teilflächen desselben Potentials kann beispielsweise über individuelle Zuführungsabschnitte, oder aber innerhalb der gemeinsamen Ebene der metallisch leitfähigen Schichten selbst erfolgen. So können beispielsweise Teilflächen gleichen Potentials bei Verwendung eines Schachbrettmusters innerhalb derselben Ebene an ihren Diagonalecken miteinander elektrisch gekoppelt sein.

Besonders vorteilhaft ist die Ausführung der mindestens einen metallisch leitfähigen Schicht einer oder beider Potentialzuführungen innerhalb des Leitbahnstapels. Bei dieser Ausführung ist der optische Schutz sowie die Abschirmwirkung gewährleistet. Gleichzeitig erhöht sich das Risiko für den Angreifer, dass ein Angriff beim Entfernen der metallischen Schichten des ersten oder zweiten Kontaktes auch weitere Metallisierungsebenen des Leitbahnstapels zumindest teilweise zerstört und damit einer Analyse nicht mehr zugänglich macht. Besonders vorteilhaft ist daher die Anordnung von einer oder mehreren Leitbahnebenen zur Verdrahtung der Schaltungskomponenten zwischen mindestens zwei metallisch leitfähigen Schichten des ersten oder zweiten Kontaktes, da hier bei einem Angriff zur Annäherung an die Bauelementschicht auch die zwischen den Kontaktschichten liegenden Leitbahnebenen entfernt werden müssten und somit die Verdrahtung der Schaltungskomponenten zerstört würde.

Auch die Anordnung einer metallisch leitfähigen Schicht der ersten Potentialzuführung oder der zweiten Potentialzuführung in einer Leitbahnebene im Leitbahnstapel, die im Vergleich mit allen anderen Leitbahnebenen des Leitbahnstapels am weitesten von der Bauelementschicht entfernt ist, ist vorteilhaft, indem sie Schutz sowohl gegen optische Inspektion, als auch gegen EMA als auch gegen Probing-basierte Angriffe bietet. Die Anordnung der metallisch leitfähigen Schicht mit großer Entfernung von der Bauelementschicht, also nahe der Oberseite des Bauelementes, sorgt dafür, dass bei einem Angriff von der Oberseite der Halbleitervorrichtung frühzeitig der erfindungsgemäße Schutzeffekt wirksam wird.

Vorteilhaft ist auch die Anordnung der ersten Potentialzuführung mit genau einer ihr zugehörigen ersten metallisch leitfähigen Schicht und der zweiten Potentialzuführung mit genau einer ihr zugehörigen zweiten metallisch leitfähigen Schicht auf benachbarten Leitbahnebenen des Leitbahnstapels. In einer solchen Anordnung sind die metallisch leitfähigen Schichten bekanntlich durch eine Isolatorschicht getrennt, so dass diese drei Flächen zusammen zugleich einen Stütz-Kondensator bilden, der Störungen in den Versorgungsleitungen unterdrückt. Auf diese Weise kann zusätzlich die Zuverlässigkeit der Schaltung verbessert werden. Auch nicht-invasive Angriffe können so zumindest erschwert werden, weil der Stütz-Kondensator die Strom-Impulse, die bei der Umschaltung der Gatter entstehen, glättet.

Besonders geeignet ist eine Ausführung der Erfindung, bei der die Vielzahl von elektronischen Schaltungskomponenten mehr als 100, insbesondere mehr als 1000 Schaltungskomponenten aufweist. Nach oben hin ist der Anzahl der Schaltungskomponenten an sich keine Grenze gesetzt. Hier kommt zum Tragen, dass der zeitliche Aufwand sowie die Komplexität der Neuverdrahtung nach einem Angriff immer größer werden, je mehr Elemente verdrahtet werden müssen.

Eine durch die Erfindung möglicherweise hervorgerufene höhere Dichte an Leitbahnen im Leitbahnstapeln kann bei Bedarf durch Hinzufügen weiterer Leitbahnebenen abgemildert werden.

Hierbei sind unter elektronischen Schaltungskomponenten Einzelbauelemente wie beispielsweise Transistoren oder Dioden, in anderen Ausführungsformen Logikgatter zu verstehen.

Weitere Ausführungsbeispiele der erfindungsgemäßen Schichtstruktur werden nachfolgend anhand der Figuren erläutert. Es zeigen:
- Fig. 1: eine schematische Darstellung einer Halbleitervorrichtung gemäß dem Stand der Technik in einer vereinfachten Explosionsdarstellung;
- Fig. 2: eine schematische Darstellung einer Ausführungsform der erfindungsgemäßen Halbleitervorrichtung in einer vereinfachten Explosionsdarstellung;
- Fig. 3: eine schematische Darstellung einer weiteren Ausführungsform der erfindungsgemäßen Halbleitervorrichtung in einer vereinfachten Explosionsdarstellung;
- Fig. 4: eine schematische Darstellung einer weiteren Ausführungsform der erfindungsgemäßen Halbleitervorrichtung in einer vereinfachten Explosionsdarstellung;
- Fig. 5 bis Fig. 9: schematische Darstellungen der Leitbahnebenen einer Halbleitervorrichtung des Standes der Technik (Fig. 5a bis Fig. 9a) und einer Ausführungsform einer erfindungsgemäßen Halbleitervorrichtung (Fig. 5b bis Fig. 9b)
- Fig. 10: schematische Darstellungen von Ausführungsformen einer metallischen Schicht in einer erfindungsgemäßen Halbleitervorrichtung.

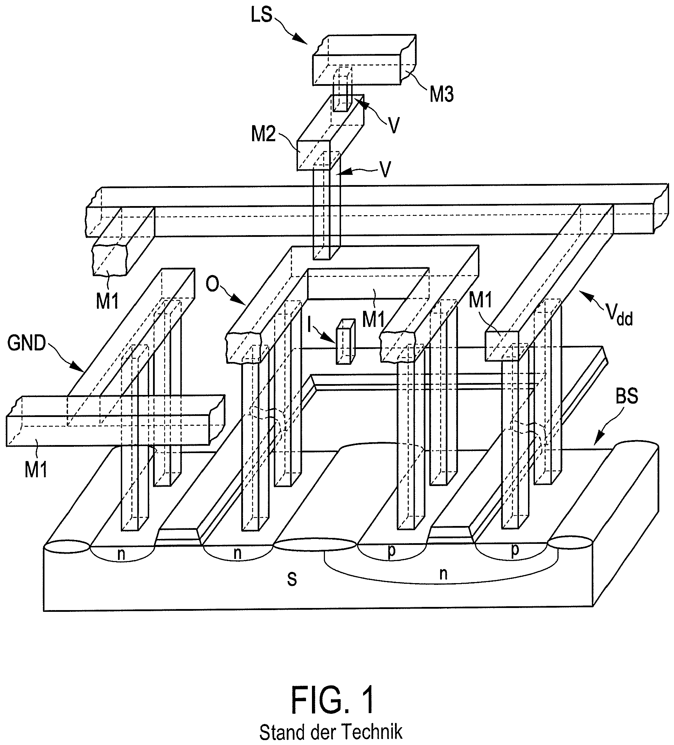

Die nachfolgenden Fig. 1 bis 3 erläutern anhand eines als Beispiel ausgewählten CMOS-Invertergatters den Unterschied zwischen Halbleitervorrichtungen gemäß dem Stand der Technik und der vorliegenden Erfindung. Die Darstellungen sind perspektivisch und stark vereinfacht. Details eines Schichtaufbaus insbesondere im Leitbahnstapel sind der Klarheit der Darstellung halber fortgelassen.

Fig. 1 zeigt zunächst eine schematische Darstellung einer solchen Halbleitervorrichtung gemäß dem Stand der Technik am Beispiel eines CMOS-Inverters. Auf einem Substrat S ist eine Bauelementschicht BS angeordnet, von der hier - als Beispiel eines Gatters - ein CMOS-Inverter mit zwei komplementären MOS-Transistoren dargestellt ist. Über der Bauelementschicht ist ein Leitbahnstapel LS umfassend drei Leitbahnebenen M1, M2 und M3 angeordnet

Die Leitbahnebene M1 umfasst Potentialzuführungen zu einem Referenzpotential GND und zu einem Versorgungspotential Vdd, sowie eine innere Gatter-Verdrahtung (I, O) als Verdrahtung der Transistoren, aus denen das Gatter besteht. Das Vorsehen der Potentialzuführungen auf der Leitbahnebene M1 ist typisch für Halbleitervorrichtungen gemäß dem Stand der Technik. Die Potentialzuführungen der Bauelemente des Inverter-Gatters zum Referenzpotential GND und Versorgungspotential V_{dd} sind hier als einzelne Leitbahnen in der Leitbahnebene M1 implementiert. Über diese Leitbahnen wird bei einer solchen Halbleitervorrichtung nach dem Stand der Technik auch die Versorgung weiterer Gatter implementiert, welche hier der Deutlichkeit der Zeichnung halber nicht dargestellt sind. Die verschiedenen Gatter teilen sich also eine gemeinsame Potentialzuführung über dafür vorgesehene Leitbahnen auf der Leitbahnebene M1. Leitbahnen verschiedener Ebenen sind über Vias V gemäß einem zugrundeliegenden Schaltungsplan miteinander verbunden, um auf den Leitbahnen I und O der Gatterverdrahtung Eingangs- und Ausgangssignale in Form elektrischer Potentiale oder Spannungen zwischen unterschiedlichen Gattern oder Einzel-Bauelementen zu übertragen.

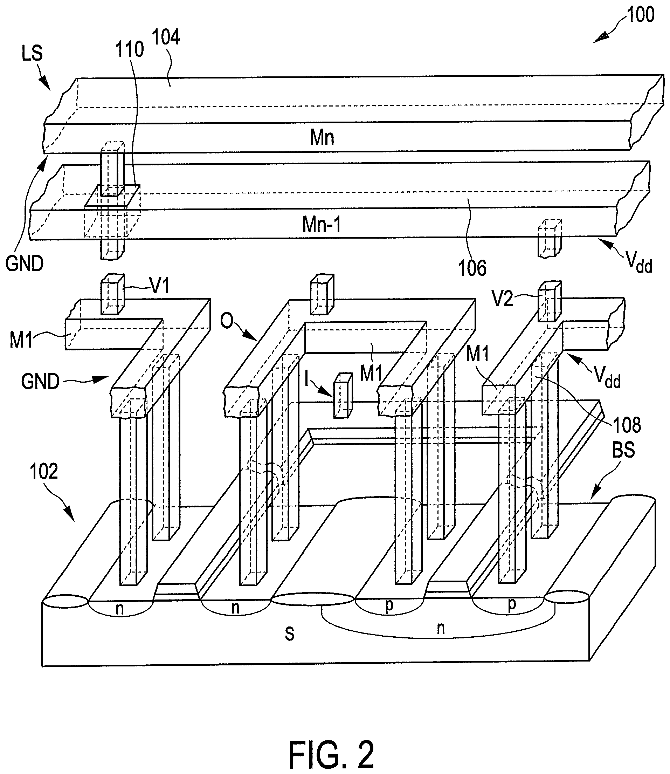

Fig. 2 ist eine schematische Darstellung einer Ausführungsform der erfindungsgemäßen Halbleitervorrichtung, wieder am Beispiel einer Halbleitervorrichtung 100, von deren vielen Schaltungskomponenten oder Logikgattern hier der Deutlichkeit halber nur ein CMOS-Inverter 102 dargestellt ist.

Die nachfolgende Beschreibung konzentriert sich auf die Unterschiede zwischen der Ausführungsform der Fig. 2 und der bekannten Ausführungsform der Fig. 1. Die Unterschiede zeigen sich im vorliegenden Ausführungsbeispiel vor allem im Leitbahnstapel, der hier n Leitbahnebenen M1 bis Mn enthält.

Zwischen der untersten Leitbahnebene M1 und der obersten Leitbahnebene Mn liegende Leitbahnebenen M2 bis Mn-2 sind vorliegend der Übersichtlichkeit halber nicht dargestellt.

Die oberste Leitbahnebene Mn ist im vorliegenden Ausführungsbeispiel als eine einzige geschlossene, großflächige, metallisch leitfähige Schicht ausgebildet, deren senkrechte Projektion auf die Bauelementschicht diese vollständig überdeckt. Es ist grundsätzlich auch möglich, eine nicht vollständige Überdeckung zu verwenden, wenn beispielsweise die nicht überdeckten Schaltungsteile der Bauelementschicht nicht geheimhaltungsbedürftig sind. Jedoch ist dann die Abschirmungswirkung gegen elektromagnetische Abstrahlung reduziert.

Die metallisch leitfähige Schicht 104 dient innerhalb der integrierten Schaltung als Potentialzuführung für ein Referenzpotential GND. Eine Verbindung der Gatter zu einem entweder außerhalb der Vorrichtung oder innerhalb der Vorrichtung bereitgestellten Referenzpotential GND erfolgt hier anders als im Stand der Technik für alle Schaltungskomponenten der Halbleitervorrichtung über diese großflächige, metallisch leitfähige Schicht 104.

Die Anordnung der metallisch leitfähigen Schicht 104 in der obersten Leitbahnebene Mn ist vorteilhaft, aber nicht zwingend. Die Schicht 104 kann zur Schaffung anderer Ausführungsformen auch auf anderen Leitbahnebenen unterhalb der obersten Leitbahnebene angesiedelt sein. Ein Vorteil der Anordnung weit oben im Leitbahnstapel liegt darin, dass auch die darunterliegenden Leitbahnstapel gegen Einsichtnahme und somit gegen eine unerwünschte Analyse der Schaltungsstruktur geschützt sind.

Das Inverter-Gatter wie auch alle anderen Gatter sind jeweils individuell mit dieser nachfolgend auch als Referenzpotentialfläche bezeichneten Schicht 104 verbunden. Am Beispiel des dargestellten Invertergatters ist erkennbar, dass diese Verbindung beispielsweise in Form eines Vias V1 realisiert werden kann, welches von der Leitbahnebene M1 ausgehend bis zur Leitbahnebene Mn geführt ist. Es ist alternativ jedoch auch möglich, die elektrische Verbindung des Invertergatters mit dem in der Leitbahnebene Mn (Referenzpotentialfläche) bereitgestellten Referenzpotential zum Teil auch horizontal innerhalb einer oder mehrerer der dazwischen liegenden Leitbahnebenen M2 bis Mn-2 zu führen. Auf diese Weise kann es noch schwerer gemacht werden, die Verdrahtung der vielen Gatter einer solchen Halbleitervorrichtung zu entschlüsseln. Wichtig ist, dass die Verbindung zwischen dem Gatter und der Referenzpotentialfläche 104 individuell realisiert ist. Aufgrund der dadurch realisierten Vielzahl von individuellen Verbindungen zwischen den einzelnen Schaltungskomponenten und der Referenzpotentialfläche 104 wird eine Analyse der Schaltung in einem Angriff praktisch unmöglich.

Das Versorgungspotential Vdd wird bei der Halbleitervorrichtung der Fig. 2 ebenfalls mit Hilfe einer bis auf Durchführungen 110 geschlossenen, großflächigen metallisch leitfähigen Schicht 106 zugeführt, die hier auf der Leitbahnebene Mn-1 angeordnet ist. Diese Schicht 106 wird nachfolgend auch als Versorgungspotentialfläche 106 bezeichnet. Großflächig bedeutet auch hier: die senkrechte Projektion der Schicht 106 auf die Bauelementschicht überdeckt diese vollständig, zumindest insoweit, dass die geheimhaltungsbedürftigen Teile der Schaltung überdeckt sind.

Das Inverter-Gatter (im folgenden Schaltungskomponente genannt), wie auch alle anderen einzelnen Gatter oder Schaltungskomponenten ist auch mit der Versorgungspotentialfläche 106 jeweils individuell verbunden. Das Versorgungspotential Vdd wird über für die einzelnen Schaltungskomponenten jeweils individuelle Vias V2 in die Leitbahnebene M1 weitergeleitet und dort, also in der Leitbahnebene M1, über Leitbahnen auf die einzelnen Gatter der Schaltungskomponente verteilt. Das hier dargestellte CMOS-Invertergatter ist zunächst mit der Leitbahn 108 und dann ausgehend von einer Leitbahn 108 der Leitbahnebene M1 über das Via V2 mit der Versorgungspotentialfläche 106 Vdd verbunden.

In der Ebene M1 ist das Inverter-Gatter außerdem mit den weiteren Gattern der Schaltungskomponente zu der es gehört verbunden. Diese Schaltungskomponente ist individuell über die gezeigten Vias mit dem Referenzpotential GND und mit dem Versorgungspotential Vdd verbunden.

Mit der Implementierung der Potentialzuführungen zum Referenzpotential GND und zum Versorgungspotential V_{dd} als metallisch leitfähige Schichten 104 und 106 wird also im Hinblick auf die Schutzwirkung zum einen von dem CMOS-Inverter im Betrieb ausgehende elektromagnetische Strahlung abgeschirmt und zum anderen der optische Zugang zur inneren Struktur der Vorrichtung erschwert, wenn nicht vollständig verhindert.. Die individuelle Ausführung der Potentialzuführung zwischen der Schicht 104, 106 und der Leitbahnebene M1 bewirkt eine gravierende Erschwerung einer Schaltungsanalyse in einem invasiven oder semiinvasiven Angriff, für den die metallisch leitfähigen Schichten 104 und 106 entfernt werden müssen. Zum einen wird die Versorgung der Schaltungskomponenten zerstört und zum anderen ist eine optische Analyse der Schaltung anhand ihrer Leitbahnstruktur nur mit einem gegenüber bekannten Lösungen sehr stark vergrößerten Einsatz an Zeit und Analysetechnik möglich, der in der Praxis nicht umsetzbar ist.

Die vorliegende Ausführungsform ist für Halbleitervorrichtungen mit drei oder mehr Leitbahnebenen geeignet. Als Material der metallisch leitfähigen Schichten können im Leitbahnstapel auch für die Leitbahnen verwendete Materialien eingesetzt werden.

Es versteht sich, dass es nicht darauf ankommt, welche Schaltungskomponenten in der Bauelementschicht angeordnet sind, sei es in Form von Einzelbauelementen oder Gattern wie etwa Logikgattern. Die Erfindung kann in den unterschiedlichsten integrierten Schaltungen Anwendung finden, seien es in Logikschaltungen, Speicherschaltungen oder in anderen Schaltungstypen. Für die Erhöhung der Wirksamkeit der erläuterten Schutzmaßnahmen ist es vorteilhaft, wenn die Schaltung eine relativ große Zahl von Schaltungskomponenten beinhaltet, die typischerweise mehr als 100, vorzugsweise mehr als 1000 beträgt.

Es ist auch möglich, nur eine der beiden Potentialflächen 104, 106 auf die eben geschilderte Weise individuell mit den Schaltungskomponenten zu verbinden. Der mit der erfindungsgemäßen Lösung erzielte Schutz gegenüber einem invasiven oder semiinvasiven Angriff wird dadurch nicht wesentlich gemindert. Auch eine Abschirmungswirkung gegen elektromagnetische Abstrahlung kann bereits mit einer einzigen großflächigen Metallschicht erzielt werden.

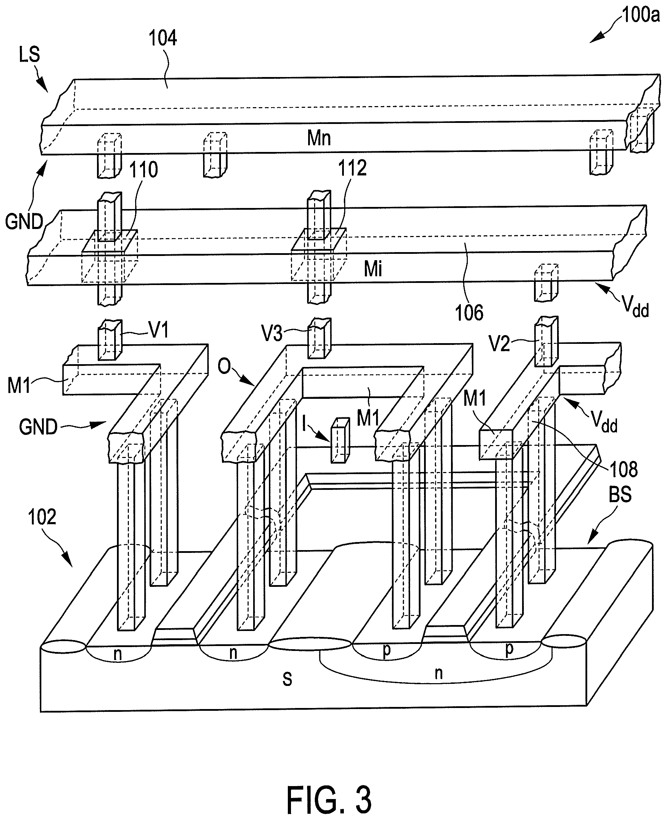

Fig. 3 zeigt eine schematische Darstellung einer weiteren Ausführungsform der erfindungsgemäßen Halbleitervorrichtung 200, welche nachfolgend wieder am Beispiel eines Ausschnitts erläutert wird, der einen CMOS-Inverter zeigt. Aufgrund der weitgehenden Ähnlichkeit mit der Ausführungsform der Fig. 2 werden nachfolgend die in Fig. 2 verwendeten Bezugszeichen für identische Strukturmerkmale auch im Zusammenhang der Beschreibung der Fig. 3 verwendet.

In der Ausführungsform der Fig. 3 ist die Versorgungspotentialfläche 106 mit größerem Abstand von der Referenzpotentialfläche 104 im Leitbahnstapel LS angeordnet. Mit anderen Worten, die beiden Schichten 104 und 106 sind nicht auf benachbarten Leitbahnebenen angeordnet. Die Schicht 106, welche die Versorgungspotentialfläche bildet, ist vielmehr auf einer Leitbahnebene Mi angeordnet, wobei i<n-1 erfüllt ist. Es befindet sich oberhalb der dargestellten Leitbahnebene Mi und unterhalb der obersten Leitbahnebene Mn mindestens eine weitere, hier nicht dargestellte Leitbahnebene Mi+1 bis Mn-1. Diese weiteren Leitbahnebenen enthalten Standard-Leitbahnen, welche Verdrahtungen zu weiteren Gattern (hier ebenfalls nicht dargestellt) bilden. Die innere Gatterverdrahtung ist über Vias V3 mit den Verdrahtungen zu weiteren Gattern verbunden. Hierzu ist jeweils eine Durchführung 112 durch die Versorgungspotentialfläche 106 vorhanden. Dargestellt ist in Fig. 3 nur ein solches Via, welches im vorliegenden Beispiel den Ausgang des CMOS-Inverters 102 mit der Verdrahtung auf den Leitbahnebenen Mi+1 bis Mn-1 verbindet.

In diesem Ausführungsbeispiel ist ein optischer Zugang/Zugriff zu den tieferen Ebenen und zur Bauelementschicht BS nur dann möglich, wenn alle Leitbahnebenen von Mi bis Mi-1 abgetragen sind. Dies führt dazu, dass auch die entsprechenden Gatter-Verdrahtungen zerstört werden müssen und eine Wiederherstellung der ursprünglichen Schaltung ohne Zusatzwissen nicht mehr möglich ist.

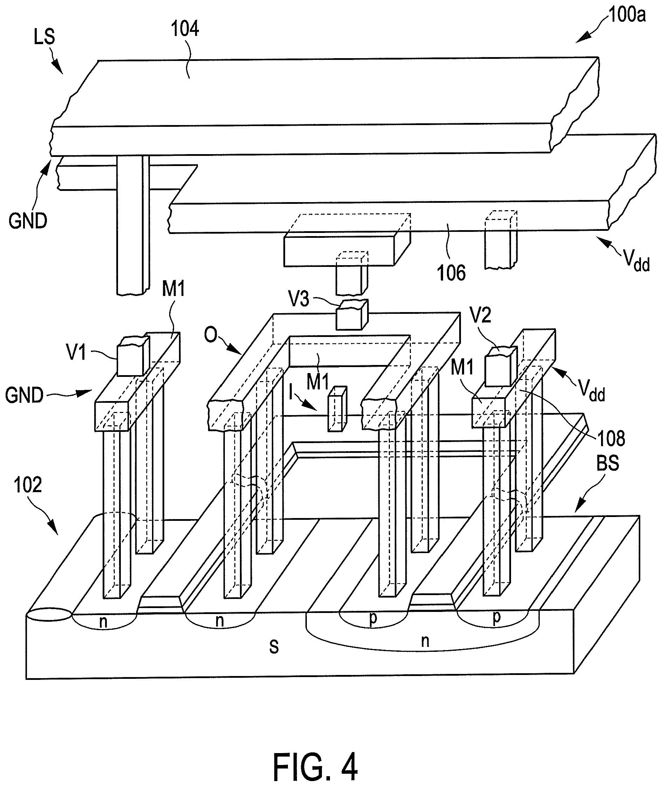

Fig. 4 eine schematische Darstellung einer weiteren Ausführungsform der erfindungsgemäßen Halbleitervorrichtung in einer vereinfachten Explosionsdarstellung am Beispiel eines einzelnen Gatters eines CMOS-Inverters. In Fig. 4 ist das einzelne dargestellte Gatter alleine über individuelle Leitbahnstrukturen, durch Vias, mit dem Referenzpotential GND und dem Versorgungspotential V_{dd} verbunden.

Fig. 4 zeigt also ein einzelnes Gatter als Schaltungskomponente, die individuell mit dem als metallische Schicht Mn ausgebildeten Referenzpotential GND und dem ebenfalls als metallische Schicht Mn-1 ausgebildeten Versorgungspotential V_{dd} verbunden ist. Die individuelle Kontaktierung einzelner Gatter an Referenzpotential und Versorgungspotential in den höher gelegenen Schichten des Leitbahnstapels erhöht den Kontaktierungsaufwand nach einem Angriff unter Zerstörung der metallischen Schichten noch weiter.

Neben der in Fig. 4 gezeigten Anordnung von Referenzpotential GND und Versorgungspotential V_{dd} in den obersten beiden Schichten des Leitbahnstapels Mn und Mn-1 kann eine Kontaktierung einzelner Gatter alternativ auch bei Anordnungen von Referenzpotential GND und Versorgungspotential V_{dd} in anderen Schichten des Leitbahnstapels mit Ausnahme der untersten Leitbahnebene M1 sowie in über dem Leitbahnstapel liegenden Ebenen vorteilhaft realisiert werden.

Die Verwendung zweier benachbarter Metallisierungsebenen für die Betriebsspannungsversorgung weist eine kapazitive Eigenschaft auf - diese ist insbesondere bei Verwendung der beiden obersten Metallisierungsebenen stark ausgeprägt - die die Beobachtbarkeit des Energieverbrauches vermindern kann und somit die Sicherheit der Schaltung erhöht.

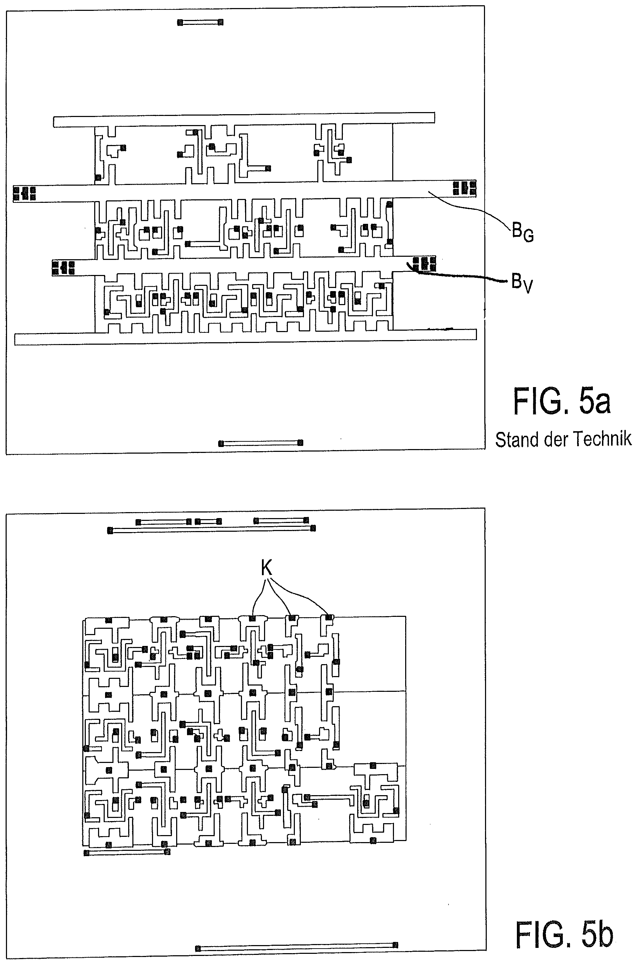

Die Fig. 5 bis Fig. 9 zeigen schematische Darstellungen der Leitbahnebenen einer Halbleitervorrichtung des Standes der Technik, Fig. 5a bis Fig. 9a, und einer Ausführungsform einer erfindungsgemäßen Halbleitervorrichtung, Fig. 5b bis Fig. 9b, beispielhaft an einem 3x3-Multiplizierer in einer Gegenüberstellung.

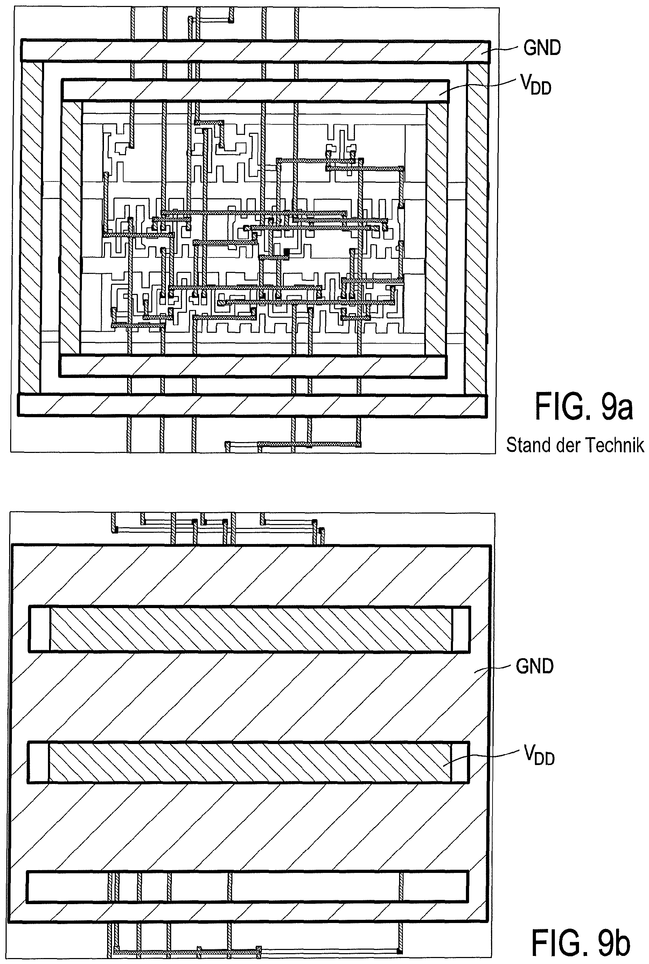

Die Darstellung beginnt in Fig. 5 mit der ersten Leitbahnebene und endet in Fig.9 mit der letzten Leitbahnebene. Die Darstellungen bauen aufeinander auf, so dass zuvor gezeigte Leitbahnebenen sichtbar bleiben, sofern sie nicht von Elementen der folgenden Leitbahnebenen überdeckt werden. Die Elemente unterschiedlicher Leitbahnebenen sind mit unterschiedlichen Schraffuren gekennzeichnet.

Fig. 5a zeigt die erste Leitbahnebene M1 eines Leitbahnstapels einer Halbleitervorrichtung des Standes der Technik. In der Leitbahnebene M1 sind die gemeinsamen Anschlüsse aller Schaltungskomponenten an Referenzpotential und Versorgungspotential als breite, zu den Seiten der Vorrichtung geführte Kontaktbahnen BG und BV implementiert. Fig. 5b hingegen zeigt die erste Leitbahnebene M1 eines Leitbahnstapels einer erfindungsgemäßen Halbleitervorrichtung. Hier sind individuelle Kontakte K zu den unter der Leitbahnebene M1 befindlichen Bauelementen zu erkennen. Eine Zuführung der Kontakte zu Referenzpotential und Versorgungspotential ist hier nicht implementiert.

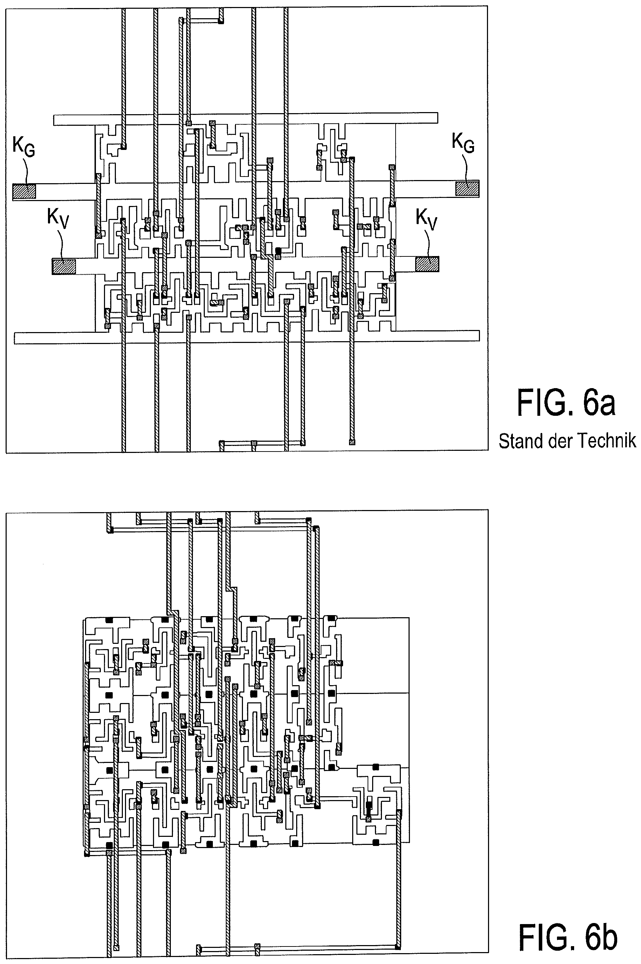

Fig. 6a zeigt die zweite Leitbahnebene der Halbleitervorrichtung des Standes der Technik. Hier wird die Verschaltung unterschiedlicher Schaltungskomponenten vorgenommen. An den Enden der Kontaktbahnen B_{G} und Bᵥ werden Kontakte K_{G} und Kᵥ für Referenzpotential und Versorgungspotential nach oben geführt. Fig. 6b zeigt die zweite Leitbahnebene der erfindungsgemäßen Halbleitervorrichtung. Auch hier werden die unterschiedlichen Schaltungskomponenten in dieser Ebene verschaltet, des Weiteren werden hier die individuellen Kontakte für Referenzpotential und Versorgungspotential nach oben geführt.

Die Führung der Kontakte zu Vdd und GND in dem Beispiel, das in Fig. 5b-9b gezeigt ist, erfolgt senkrecht. Sie kann aber auch derart implementiert werden, dass in bestimmten Leitebenen der Kontakt zunächst horizontal geführt wird und dann an einer nicht senkrecht über dem Bauelement liegenden Stelle weiter vertikal geführt wird. Durch diese vertikalen und horizontalen Kontaktführungen wird der Aufwand für Rekonstruktionen der Kontaktierungen zusätzlich erschwert.

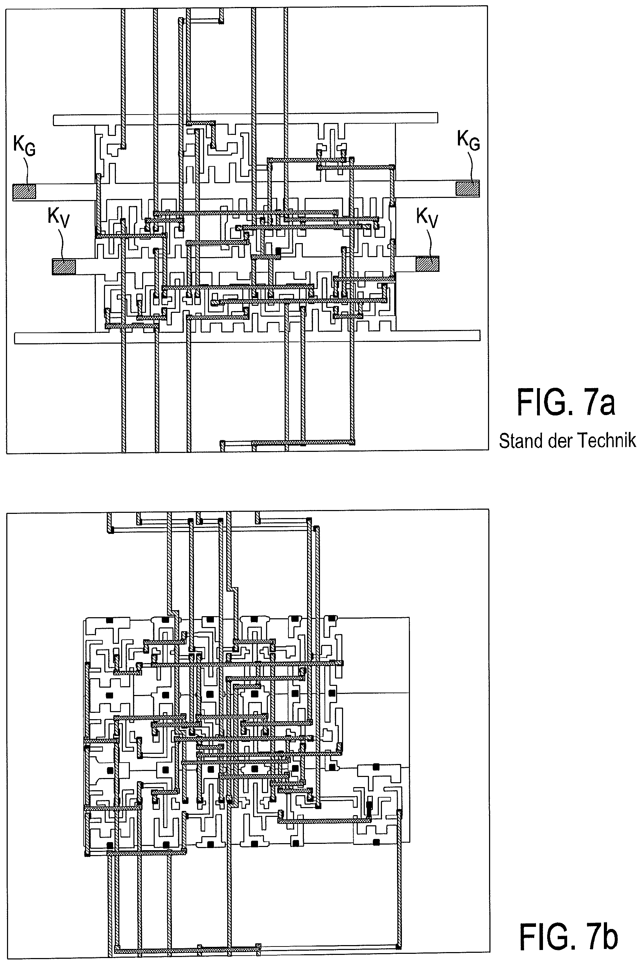

Fig. 7a und Fig 7b zeigen die dritten Leitbahnebenen M3. Wie bereits in der zweiten Ebene werden hier wiederum Verschaltungen der Schaltungskomponenten vorgenommen und die Kontakte zu Referenzpotential und Versorgungspotential weiter nach oben geführt. Für alle Komponenten gemeinsam über die Kontakte K_{G} und Kᵥ im Stand der Technik (Fig. 7a) und individuell in der erfindungsgemäßen Vorrichtung (Fig. 7b).

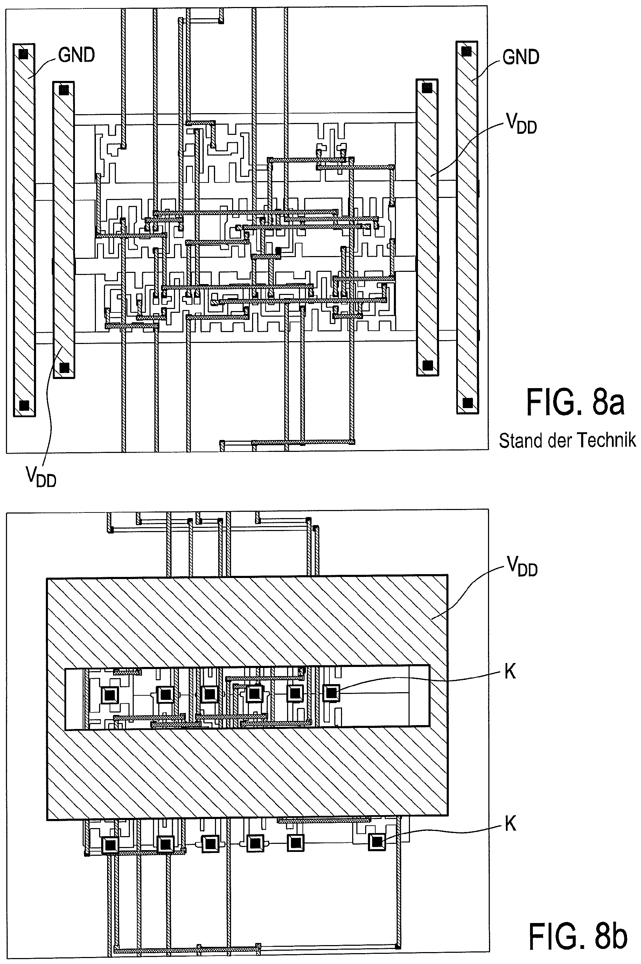

Fig. 8a zeigt die Implementierung von jeweils Teilen des Referenzpotentials GND und des Versorgungspotentials V_{DD} in Form von Metallstreifen in Leitbahnebene M4 im Stand der Technik. Hier wird deutlich dass die Verschaltung der Komponenten nicht von den Potentialen verdeckt wird. Fig. 8b zeigt die Implementierung des Versorgungspotentials V_{DD} in Form einer Metallschicht, die Teile der Komponenten der Halbleitervorrichtung überdeckt und so auch optischen Schutz bietet. In den noch freiliegenden Bereichen sind Kontaktführungen K für die Kontaktierung zum Referenzpotential GND implementiert.

Fig. 9a zeigt die letzte Leitbahnebene M5 im Stand der Technik. In dieser Ebene ist die Implementierung von Referenzpotential GND und Versorgungspotential V_{DD} abgeschlossen. Beide Potentiale stellen in der Draufsicht einen Rahmen um die Verschaltung der Komponenten dar, die weiterhin, nicht von einer metallischen Schicht bedeckt ist. In Fig. 9b ist die Implementierung des Referenzpotentials GND als Metallschicht dargestellt. Damit ist die Halbleitervorrichtung nun durch Referenzpotential und Versorgungspotential optisch vollständig verborgen. Die in Fig. 9b gezeigte Metallschicht ist nicht durchgängig sondern weist zwei Öffnungen auf, unter denen sich durchgehende Bereiche der Metallschicht des Versorgungspotentials V_{DD} befinden.

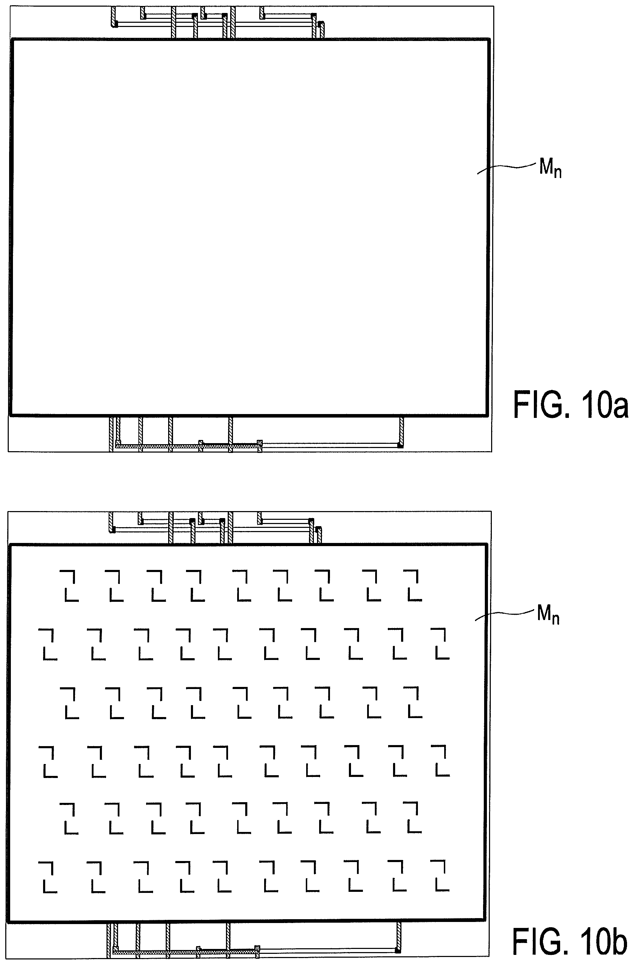

Fig. 10a zeigt eine weitere Ausführungsform der obersten Metallschicht Mn einer erfindungsgemäßen Halbleitervorrichtung, die als Referenzpotential genutzt wird. Hier ist die Metallschicht durchgehend und ohne Öffnungen ausgebildet. Ebenso liegt es im Rahmen der Erfindung die oberste Metallschicht mit kleinen Öffnungen (z. B. Schlitzen wie in Fig. 10b) zu verwenden. Diese Öffnungen dienen der Vermeidung mechanischer Spannungen.

## Patentansprüche

1. Halbleitervorrichtung (100, 100a) mit
- einem Substrat (S),
- einer Bauelementschicht (BS) auf dem Substrat, welche eine Vielzahl von elektronischen Schaltungskomponenten in Form von monolithisch integrierten Einzel-Bauelementen oder Gattern (102) beinhaltet,
- einem Leitbahnstapel (LS) auf einer vom Substrat abgewandten Seite der Bauelementschicht,
- einer ersten monolithisch integrierten Potentialzuführung , die mit einem elektrischen Referenz-Potential (GND) verbunden oder verbindbar ist, und
- einer zweiten monolithisch integrierten Potentialzuführung , die mit einem elektrischen Versorgungspotential (VDD) verbunden oder verbindbar ist, wobei
- die erste Potentialzuführung oder die zweite Potentialzuführung oder die erste und die zweite Potentialzuführung jeweils mindestens eine metallisch leitfähige Schicht (104, 106) aufweisen, wobei in der letztgenannten Alternative die metallisch leitfähige Schicht der ersten und der zweiten Potentialführung von einander elektrisch isoliert sind, und wobei
- die metallisch leitfähige Schicht der ersten (104) und/oder der zweiten Potentialzuführung (106), mit allen Schaltungskomponenten jeweils einzeln über jeweils individuelle Leitbahnstrukturen (V1, V2) direkt verbunden sind.

2. Halbleitervorrichtung nach Anspruch 1, **dadurch gekennzeichnet, dass** mindestens eine der Potentialzuführungen nicht in einer untersten Metallisierungsebene (M1) des Leitbahnstapels (LS) realisiert ist.

3. Halbleitervorrichtung nach Anspruch 1 oder zwei, **dadurch gekennzeichnet, dass** die mindestens eine metallisch leitfähige Schicht der ersten (104) oder der zweiten Potentialzuführung (106) eine Fläche bildet, die entweder vollständig ohne Öffnungen ist oder abgesehen von mindestens einer Via-Durchführung oder von geringfügigen Öffnungen zur Vermeidung mechanischer Spannungen ohne Öffnungen ist und deren senkrechte Projektion auf die Bauelementschicht diese im wesentlichen oder vollständig überdeckt.

4. Halbleitervorrichtung nach Anspruch 1 oder 2, **dadurch gekennzeichnet, dass** die mindestens eine metallisch leitfähige Schicht der ersten oder der zweiten Potentialzuführung oder beider Potentialführungen ein in einer einzigen Schichtebene liegendes Netz oder ein in einer einzigen Schichtebene liegendes Gitter bildet, welches mit seinen lateralen Ausmaßen in senkrechter Projektion auf die Bauelementschicht diese im wesentlichen oder vollständig überdeckt.

5. Halbleitervorrichtung nach Anspruch 1 oder 2, **dadurch gekennzeichnet, dass** mindestens eine der metallisch leitfähigen Schichten Durchführungen (110, 112) aufweist, durch welche senkrecht zur Schicht verlaufende Vias (V1, V2, V3) geführt sind.

6. Halbleitervorrichtung nach einem der Ansprüche 1 bis 5und besagter letztgenannten Alternative, **dadurch gekennzeichnet, dass** genau eine erste metallisch leitfähige Schicht der ersten Potentialzuführung und genau eine zweite metallisch leitfähige Schicht der zweiten Potentialzuführung auf in seiner Stapelrichtung benachbarten Leitbahnebenen (Mn, Mn-1) des Leitbahnstapels (LS) angeordnet sind.

7. Halbleitervorrichtung nach einem der Ansprüche 1 bis 6, **dadurch gekennzeichnet, dass** nur eine der Potentialzuführungen, also entweder mindestens eine metallisch leitfähige Schicht der ersten Potentialzuführung oder mindestens eine metallisch leitfähige Schicht der zweiten Potentialzuführung innerhalb des Leitbahnstapels (LS) ausgeführt ist.

8. Halbleitervorrichtung nach Anspruch 1 oder 2 und besagter letztgenannten Alternative, **dadurch gekennzeichnet, dass** die metallisch leitfähige Schicht der ersten und der zweiten Potentialzuführung lateral benachbart in einer gemeinsamen, parallel zu einer Hauptoberfläche des Substrats liegenden Ebene angeordnet sind und von einander elektrisch isoliert sind.

9. Halbleitervorrichtung nach Anspruch 8, **dadurch gekennzeichnet, dass**, abgesehen von einem lateralen Abstand für die elektrische Isolierung der beiden metallisch leitfähigen Schichten der ersten und der zweiten Potentialzuführung voneinander innerhalb der gemeinsamen Ebene, eine senkrechte Projektion dieser metallisch leitfähigen Schichten der ersten und der zweiten Potentialzuführung auf die Bauelementschicht die Bauelementschicht im Wesentlichen oder vollständig überdeckt.

10. Halbleitervorrichtung nach einem der Ansprüche 1 bis 5 und besagter letztgenannten Alternative, **dadurch gekennzeichnet, dass** beide Potentialzuführungen , also mindestens eine metallisch leitfähige Schicht der ersten Potentialzuführung (104) und mindestens eine metallisch leitfähige Schicht (106) der zweiten Potentialzuführung innerhalb des Leitbahnstapels (LS) ausgeführt sind.

11. Halbleitervorrichtung nach einem der vorstehenden Ansprüche, **dadurch gekennzeichnet, dass** die metallisch leitfähige Schicht der ersten oder der zweiten oder beider Potentialzuführungen, oder, bei Vorhandensein mehrerer metallischer Schichten einer jeweiligen Potentialzuführung, eine metallisch leitfähige Deckschicht der ersten oder der zweiten oder beider Potentialzuführungen im Leitbahnstapel in einer Leitbahnebene (Mn) angeordnet ist, die im Vergleich mit allen anderen Leitbahnebenen des Leitbahnstapels am weitesten von der Bauelementschicht entfernt ist.

12. Halbleitervorrichtung nach einem der Ansprüche 1 bis 11, **dadurch gekennzeichnet, dass** zwischen zwei metallisch leitfähigen Schichten (104, 106) entweder derselben Potentialzuführung oder unterschiedlicher Potentialzuführungen eine oder mehrere Leitbahnebenen des Leitbahnstapels (LS) ausgeführt sind.

13. Halbleitervorrichtung nach einem der vorstehenden Ansprüche, **dadurch gekennzeichnet, dass** die Vielzahl von elektronischen Schaltungskomponenten mehr als 100 Schaltungskomponenten aufweist.

14. Halbleitervorrichtung nach einem der vorstehenden Ansprüche, **dadurch gekennzeichnet, dass** die Vielzahl von elektronischen Schaltungskomponenten mehr als 1000 Schaltungskomponenten aufweist.

## Claims

1. Semiconductor device (100, 100a) having
- a substrate (S)
- a component layer (BS) on the substrate, which component layer contains a plurality of electronic circuit components in the form of monolithically integrated individual components or gates (102),
- a conductive path stack (LS) on a side of the component layer facing away from the substrate,
- a first monolithically integrated potential supply, which is connected or can be connected to an electrical reference potential (GND), and
- a second monolithically integrated potential supply, which is connected or can be connected to an electrical supply potential (VDD), wherein
- the first potential supply or the second potential supply or the first and the second potential supply in each case have at least one metallically conductive layer (104, 106), wherein in the latter alternative the metallically conductive layer of the first and the second potential guide are electrically insulated from one another, and wherein
- the metallically conductive layer of the first (104) and/or the second potential supply (106), are each directly and individually connected to all circuit components via respective individual conductive path structures (V1, V2).

2. Semiconductor device according to claim 1, **characterised in that** at least one of the potential supplies is not provided in a lowest metallisation plane (M1) of the conductive path stack (LS).

3. Semiconductor device according to claim 1 or two, **characterised in that** the at least one metallically conductive layer of the first (104) or the second potential supply (106) forms a surface which is either completely without openings or, apart from at least one via-feedthrough or apart from slight openings for avoiding mechanical stresses, is without openings and whose perpendicular projection onto the component layer substantially or completely covers said component layer.

4. Semiconductor device according to claim 1 or 2, **characterised in that** the at least one metallically conductive layer of the first or the second potential supply or of both potential guides forms a network lying in a single layer plane or a grid lying in a single layer plane, which network or grid substantially or completely covers the component layer with its lateral dimensions in a perpendicular projection onto the component layer.

5. Semiconductor device according to claim 1 or 2, **characterised in that** at least one of the metallically conductive layers has feedthroughs (110, 112), through which vias (V1, V2, V3) running perpendicular to the layer are guided.

6. Semiconductor device according to any of claims 1 to 5 and said latter alternative, **characterised in that** exactly one first metallically conductive layer of the first potential supply and exactly one second metallically conductive layer of the second potential supply are arranged on conductive path planes (Mn, Mn-1) of the conductive path stack (LS) that are adjacent in its stack direction.

7. Semiconductor device according to any of claims 1 to 6, **characterised in that** only one of the potential supplies, that is, either at least one metallically conductive layer of the first potential supply or at least one metallically conductive layer of the second potential supply, is arranged within the conductive path stack (LS).

8. Semiconductor device according to claim 1 or 2 and said latter alternative, **characterised in that** the metallically conductive layer of the first and the second potential supply are arranged laterally adjacent to one another in a common plane lying parallel to a main surface of the substrate and are electrically insulated from one another.

9. Semiconductor device according to claim 8, **characterised in that**, apart from a lateral distance for the electrical insulation of the two metallically conductive layers of the first and the second potential supply from one another within the common plane, a perpendicular projection of said metallically conductive layers of the first and the second potential supply onto the component layer substantially or completely covers the component layer.

10. Semiconductor device according to any of claims 1 to 5 and said latter alternative, **characterised in that** both potential supplies, that is, at least one metallically conductive layer of the first potential supply (104) and at least one metallically conductive layer (106) of the second potential supply, are arranged within the conductive path stack (LS).

11. Semiconductor device according to any of the preceding claims, **characterised in that** the metallically conductive layer of the first or the second or both potential supplies, or, when several metallic layers of a respective potential supply are present, a metallically conductive covering layer of the first or the second or both potential supplies is arranged in the conductive path stack in a conductive path plane (Mn) which, in comparison to all other conductive path planes of the conductive path stack, is furthest away from the component layer.

12. Semiconductor device according to claims 1 to 11, **characterised in that** one or more conductive path planes of the conductive path stack (LS) are arranged between two metallically conductive layers (104, 106) of either the same potential supply or different potential supplies.

13. Semiconductor device according to any of the preceding claims, **characterised in that** the plurality of electronic circuit components has more than 100 circuit components.

14. Semiconductor device according to any of the preceding claims, **characterised in that** the plurality of electronic circuit components has more than 1000 circuit components.

## Revendications

1. Dispositif semi-conducteur (100, 100a) avec
- un substrat (S),
- une couche de composants (BS) sur le substrat, qui contient une pluralité de composants de circuits électroniques sous la forme de composants individuels ou de portes logiques (102) intégrées de manière monolithique,
- une pile de pistes conductrices (LS) sur un côté de la couche de composant opposée au substrat,
- une première ligne de potentiel, intégrée de manière monolithique, qui est reliée ou qui peut être reliée avec un potentiel de référence électrique (GND) et
- une deuxième ligne de potentiel, intégrée de manière monolithique, qui est reliée ou qui peut être reliée avec un potentiel d'alimentation (VDD), dans laquelle
- la première ligne de potentiel ou la deuxième ligne de potentiel ou la première ligne de potentiel et la deuxième ligne de potentiel comprennent chacune au moins une couche métallique conductrice (104, 106), dans laquelle, dans la variante mentionnée en dernier, les couches métalliques conductrices de la première ligne de potentiel et de la deuxième ligne de potentiel sont isolées électriquement l'une de l'autre et dans laquelle
- les couches métalliques conductrices de la première (104) et/ou de la deuxième ligne de potentiel (106) sont reliées chacune directement et individuellement par l'intermédiaire de structures de pistes conductrices individuelles (V1, V2).

2. Dispositif semi-conducteur selon la revendication 1, **caractérisé en ce que** l'au moins une des alimentations en potentiel n'est pas réalisée dans un plan de métallisation inférieur (M1) de la pile de pistes conductrices (LS).

3. Dispositif semi-conducteur selon la revendication 1 ou deux, **caractérisé en ce que** l'au moins une couche métallique conductrice de la première (104) et/ou de la deuxième ligne de potentiel (106) constitue une surface qui est soit entièrement sans ouvertures soit est sans ouvertures à l'exception d'au moins un passage de traversée ou de petites ouvertures, afin d'éviter des contraintes mécaniques et dont la projection perpendiculaire sur la couche de composants recouvre celle-ci globalement ou entièrement.

4. Dispositif semi-conducteur selon la revendication 1 ou 2, **caractérisé en ce que** l'au moins une couche métallique conductrice de la première ou de la deuxième ligne de potentiel ou les deux alimentations en potentiel constitue un réseau se trouvant dans un seul plan de couche ou une grille se trouvant dans un seul plan de couche, qui recouvre celle-ci globalement ou entièrement avec ses dimensions latérales en projection perpendiculaire sur la couche de composants.

5. Dispositif semi-conducteur selon la revendication 1 ou 2, **caractérisé en ce qu'**au moins une des couches métalliques conductrices comprend des traversées (110, 112) à travers lesquels sont guidés des passages de traversée (V1, V2, V3) s'étendant perpendiculairement à la couche.

6. Dispositif semi-conducteur selon l'une des revendications 1 à 5 et ladite dernière variante mentionnée, **caractérisé en ce qu'**exactement une couche métallique conductrice de la première ligne de potentiel et exactement une couche métallique conductrice de la deuxième ligne de potentiel sont disposées sur des plans de pistes de conductrices (Mn, Mn-1) de la pile de pistes conductrices (LS), adjacents dans sa direction d'empilement.

7. Dispositif semi-conducteur selon l'une des revendications 1 à 6, **caractérisé en ce que** seule une des alimentations en potentiel, donc soit au moins une couche métallique conductrice de la première ligne de potentiel et au moins une couche métallique conductrice de la deuxième ligne de potentiel est réalisée à l'intérieur de la pile de pistes conductrices (LS).

8. Dispositif semi-conducteur selon l'une des revendications 1 ou 2 et ladite dernière variante mentionnée, **caractérisé en ce que** les couches métalliques conductrices des première et deuxième alimentations en potentiel sont disposées de manière adjacente latéralement dans un plan commun parallèle à une surface principale du substrat et sont isolées électriquement l'une par rapport à l'autre.

9. Dispositif semi-conducteur selon la revendication 8, **caractérisé en ce que**, à l'exception d'une distance latérale pour l'isolation électrique des deux couches métalliques conductrices des première et deuxième alimentations en potentiel l'une par rapport à l'autre, à l'intérieur du plan commun, une projection perpendiculaire de ces couches métalliques conductrices des première et deuxième alimentations en potentiel sur la couche de composants recouvre globalement ou entièrement la couche de composants.

10. Dispositif semi-conducteur selon l'une des revendications 1 à 5 et ladite dernière variante mentionnée, **caractérisé en ce que** les deux alimentations en potentiel, donc au moins une couche métallique conductrice de la première ligne de potentiel (104) et au moins une couche métallique conductrice (106) de la deuxième ligne de potentiel sont réalisées à l'intérieur de la pile de pistes conductrices (LS).

11. Dispositif semi-conducteur selon l'une des revendications précédentes, **caractérisé en ce que** la couche métallique conductrice de la première ou de la deuxième ou des deux alimentations en potentiel ou, lors de la présence de plusieurs couches métalliques d'une ligne de potentiel respective, une couche de recouvrement métallique conductrice de la première ou de la deuxième ou des deux alimentations en potentiel est disposée dans la pile de pistes conductrices dans un plan de piste conductrice (Mn), qui est le plus éloigné de la couche de composants par rapport à tous les autres plans de pistes conductrices de la pile de pistes conductrices.

12. Dispositif semi-conducteur selon l'une des revendications 1 à 11, **caractérisé en ce que**, entre deux couches métalliques conductrices (104, 106), soit de la même ligne de potentiel soit d'alimentations en potentiel différentes, sont réalisés un ou plusieurs plans de pistes conductrices de la pile de pistes conductrices (LS).

13. Dispositif semi-conducteur selon l'une des revendications précédentes, **caractérisé en ce que** la pluralité de composants de circuits électroniques comprend plus de 100 composants de circuits.

14. Dispositif semi-conducteur selon l'une des revendications précédentes, **caractérisé en ce que** la pluralité de composants de circuits électroniques comprend plus de 1000 composants de circuits.
